# EUROPEAN PATENT APPLICATION

(11) **EP 3 919 578 A1**
(43) Date of publication of application: **08.12.2021**
(21) Application number: 21175263.9
(22) Date of filing: 21.05.2021
(51) Int. Cl.: C09J 7/38, C09J 7/29

(54) **PRESSURE-SENSITIVE ADHESIVE SHEET FOR SEMICONDUCTOR PROCESSING**

(30) Priority: 02.06.2020 JP 2020096050
(71) Applicant: Nitto Denko Corporation, Ibaraki-shi, Osaka 567-8680 (JP)
(72) Inventor: TANAKA, Shunpei, Ibaraki-shi, 567-8680 (JP); KONO, Hiroki, Ibaraki-shi, 567-8680 (JP); UENO, Taiki, Ibaraki-shi, 567-8680 (JP)
(74) Representative: Grünecker Patent- und Rechtsanwälte PartG mbB

(57) **Abstract**

Provided is a pressure-sensitive adhesive sheet for semiconductor processing that appropriately protects a semiconductor wafer without reducing a yield. The pressure-sensitive adhesive sheet for semiconductor processing includes a pressure-sensitive adhesive layer and a base material. The pressure-sensitive adhesive sheet for semiconductor processing shows a warping amount of from 0 mm to 5 mm in an outer peripheral rib wafer heat warping evaluation, and shows a deflection amount of from 0 mm to 5 mm in an outer peripheral rib wafer deflection evaluation.

## Description

This application claims priority under 35 U.S.C. Section 119 to Japanese Patent Application No. 2020-096050 filed on June 2, 2020, which is herein incorporated by reference.

### BACKGROUND OF THE INVENTION

### 1. Field of the Invention

The present invention relates to a pressure-sensitive adhesive sheet for semiconductor processing.

### 2. Description of the Related Art

In a backgrinding process, a semiconductor wafer may be ground to such a thickness that it is difficult to handle the wafer alone. Accordingly, to improve handleability in a subsequent process, the semiconductor wafer has been fixed onto a support wafer via an adhesive. However, treatment for the dissolution of the adhesive with a solvent is required at the time of the peeling of the semiconductor wafer from the support wafer, and hence problems in terms of cost and environmental load occur.

In recent years, the semiconductor wafer brought into a thinned state through the backgrinding process has been subjected to a heating process, such as an ion implantation process or an annealing treatment process. Accordingly, there has been proposed a technology of protecting the semiconductor wafer with a pressure-sensitive adhesive sheet not only in the backgrinding process but also in the heating process (Japanese Patent Application Laid-open No. 2005-236032). However, there is a problem in that warping occurs in the semiconductor wafer having bonded thereto the pressure-sensitive adhesive sheet at the time of its heating. When the warping occurs, there is a risk in that it becomes difficult to convey the wafer with an apparatus, and hence a yield reduces.

As a technology of securing handleability, there has been proposed a method of forming such a semiconductor wafer that its outer periphery is thicker than its inside (so-called TAIKO (trademark) wafer, hereinafter also referred to as "outer peripheral rib wafer") (Japanese Patent No. 5,390,740). According to the technology, the heating process can be performed by using the semiconductor wafer alone. However, in the handling of the TAIKO wafer alone, the surface (circuit surface) of the semiconductor wafer is exposed, and hence the contamination, damage, or the like of the circuit surface is liable to occur. Accordingly, a product may not be obtained in a sufficient yield. Further, an increase in diameter of a wafer has been advanced for improving the production efficiency of a semiconductor apparatus. Along with an increase in diameter of the outer peripheral rib wafer, deflection may occur in the wafer. When the deflection occurs, there is a risk in that it becomes difficult to convey the semiconductor wafer with an apparatus, and hence the yield reduces.

### SUMMARY OF THE INVENTION

The present invention has been made to solve the problems of the related art, and an object of the present invention is to provide a pressure-sensitive adhesive sheet for semiconductor processing that appropriately protects a semiconductor wafer without reducing a yield.

According to at least one embodiment of the present invention, there is provided a pressure-sensitive adhesive sheet for semiconductor processing, including a pressure-sensitive adhesive layer and a base material. The pressure-sensitive adhesive sheet for semiconductor processing shows a warping amount of from 0 mm to 5 mm in an outer peripheral rib wafer heat warping evaluation, and shows a deflection amount of from 0 mm to 5 mm in an outer peripheral rib wafer deflection evaluation.

In at least one embodiment of the present invention, the base material has a storage modulus of elasticity of 2×10⁹ Pa or more at 23°C, and has a storage modulus of elasticity of 2×10⁸ Pa or more at 180°C.

In at least one embodiment of the present invention, the base material has a thickness of from 50 µm to 200 µm.

In at least one embodiment of the present invention, the pressure-sensitive adhesive sheet for semiconductor processing further includes a relaxing layer.

In at least one embodiment of the present invention, the relaxing layer contains a cross-linked product obtained by cross-linking a (meth)acrylic polymer.

In at least one embodiment of the present invention, the (meth)acrylic polymer is free of (meth)acrylic acid as a monomer component.

In at least one embodiment of the present invention, the (meth)acrylic polymer contains 0.1 mol% to 8 mol% of a hydroxy group-containing (meth)acrylic monomer.

In at least one embodiment of the present invention, the (meth)acrylic polymer contains 50 mol% to 99 mol% of a (meth)acrylic monomer having an alkyl group having 4 or less carbon atoms.

In at least one embodiment of the present invention, the pressure-sensitive adhesive layer contains a UV-curable pressure-sensitive adhesive.

In at least one embodiment of the present invention, the relaxing layer is free of UV curability.

### BRIEF DESCRIPTION OF THE DRAWINGS

FIG. 1 is a schematic sectional view of a pressure-sensitive adhesive sheet for semiconductor processing according to at least one embodiment of the present invention.
FIG. 2 is a schematic sectional view of a pressure-sensitive adhesive sheet for semiconductor processing according to at least one embodiment of the present invention.
FIG. 3 is a schematic view for illustrating a method of measuring deflection in an outer peripheral rib wafer deflection evaluation.

### DESCRIPTION OF THE EMBODIMENTS

A. Overall Configuration of Pressure-sensitive Adhesive Sheet for Semiconductor Processing

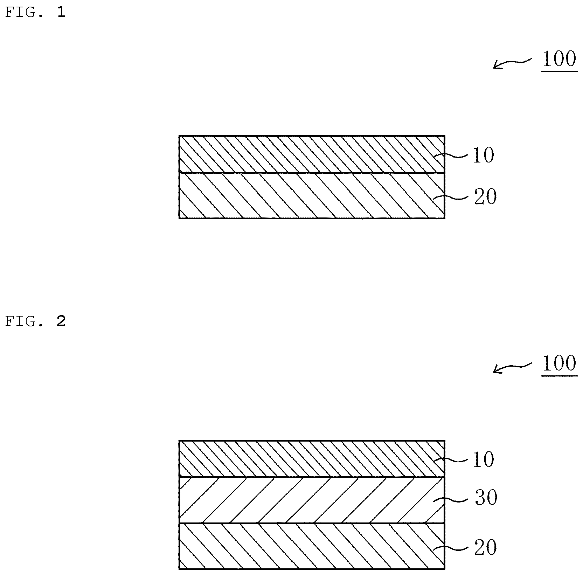

FIG. 1 is a schematic sectional view of a pressure-sensitive adhesive sheet for semiconductor processing according to at least one embodiment of the present invention. A pressure-sensitive adhesive sheet 100 for semiconductor processing includes a base material 10 and a pressure-sensitive adhesive layer 20 arranged on one surface of the base material. The pressure-sensitive adhesive sheet for semiconductor processing may include any appropriate other layer (not shown). For example, any appropriate layer may be formed between the base material and the pressure-sensitive adhesive layer. FIG. 2 is a schematic sectional view of a pressure-sensitive adhesive sheet for semiconductor processing according to at least one embodiment of the present invention. In this embodiment, the pressure-sensitive adhesive sheet 100 for semiconductor processing includes the base material 10, a relaxing layer 30, and the pressure-sensitive adhesive layer 20 in the stated order. In the illustrated example, the base material 10 is a single layer, but the pressure-sensitive adhesive sheet for semiconductor processing may include two or more base materials. The two or more base materials may be laminated so as to be in contact with each other, or the base materials may be laminated through intermediation of any other layer. For example, in the pressure-sensitive adhesive sheet for semiconductor processing, a first base material, the relaxing layer, a second base material, and the pressure-sensitive adhesive layer may be laminated in the stated order. Until the pressure-sensitive adhesive sheet for semiconductor processing is brought into use, a separator may be arranged outside the pressure-sensitive adhesive layer for the purpose of protecting the pressure-sensitive adhesive layer.

In at least one embodiment of the present invention, the warping amount of the pressure-sensitive adhesive sheet for semiconductor processing in an outer peripheral rib wafer heat warping evaluation is from 0 mm to 5 mm. When the warping amount in the outer peripheral rib wafer heat warping evaluation falls within the range, even in the case where a wafer is subjected to a heating process under a state in which the pressure-sensitive adhesive sheet for semiconductor processing is bonded thereto, the occurrence of its warping can be suppressed, and hence the conveyance of the wafer with an apparatus can be efficiently performed. Accordingly, a reduction in yield can be suppressed. The warping amount in the outer peripheral rib wafer heat warping evaluation is preferably from 0 mm to 4.5 mm, more preferably from 0 mm to 4 mm, still more preferably from 0 mm to 3.5 mm. The warping amount is preferably as small a value as possible. In this specification, the warping amount in the outer peripheral rib wafer heat warping evaluation refers to a value measured by a method described in Examples to be described later.

In at least one embodiment of the present invention, the deflection amount of the pressure-sensitive adhesive sheet for semiconductor processing in an outer peripheral rib wafer deflection evaluation is from 0 mm to 5 mm. When the deflection amount falls within the range, even in the case where the diameter of a semiconductor wafer is increased, the wafer can be appropriately supported, and hence a reduction in yield can be prevented. Further, the conveyance of the wafer with an apparatus can be efficiently performed, and hence the reduction in yield can be prevented. The deflection amount in the outer peripheral rib wafer deflection evaluation is preferably from 0 mm to 4.5 mm, more preferably from 0 mm to 4 mm, still more preferably from 0 mm to 3.5 mm. The deflection amount is preferably as small a value as possible. In this specification, the deflection amount in the outer peripheral rib wafer deflection evaluation refers to a value measured by a method described in Examples to be described later.

The thickness of the pressure-sensitive adhesive sheet for semiconductor processing according to at least one embodiment of the present invention may be set to any appropriate thickness. For example, the thickness of the pressure-sensitive adhesive sheet for semiconductor processing is preferably from 50 µm to 900 µm, more preferably from 100 µm to 800 µm, still more preferably from 150 µm to 750 µm. When the thickness falls within the ranges, even in the case where the sheet is subjected to a heating process, the sheet can appropriately support a semiconductor wafer, and hence its handleability can be maintained. In addition, the conveyance of the wafer with an apparatus can be efficiently performed, and hence a reduction in yield can be prevented. When the thickness is more than 900 µm, the processability and handleability of the pressure-sensitive adhesive sheet for semiconductor processing may reduce.

### B. Base Material

In at least one embodiment of the present invention, the storage modulus of elasticity of the base material at 23°C is preferably 1×10⁹ Pa or more, more preferably 2×10⁹ Pa or more, still more preferably 2.5×10⁹ Pa or more. When the storage modulus of elasticity at 23°C falls within the ranges, a semiconductor wafer is appropriately supported, and hence its deflection can be suppressed. The storage modulus of elasticity of the base material at 23°C is preferably as high as possible. The storage modulus of elasticity of the base material at 23°C is, for example, 1×10¹⁰ Pa or less. In this specification, the storage modulus of elasticity of the base material refers to a storage modulus of elasticity measured by using a sample having a film thickness of 100 µm, a length of 25 mm (measured length), and a width of 10 mm, the sample being produced by using a material for forming the base material.

In at least one embodiment of the present invention, the storage modulus of elasticity of the base material at 180°C is preferably 2×10⁸ Pa or more, more preferably 2.1×10⁸ Pa or more, still more preferably 2.3×10⁸ Pa or more. When the storage modulus of elasticity at 180°C falls within the ranges, even in the case where the sheet is subjected to a heating process, the sheet can appropriately support the semiconductor wafer. As described above, in a processing process for the semiconductor wafer, the sheet may be subjected to the heating process. Even when the sheet is subjected to the processing process for the semiconductor wafer including such heating process, the sheet can appropriately support the semiconductor wafer. The storage modulus of elasticity of the base material at 180°C is preferably as high as possible. The storage modulus of elasticity of the base material at 180°C is, for example, 1×10¹⁰ Pa or less.

The thickness of the base material is preferably from 50 µm to 200 µm, more preferably from 60 µm to 180 µm, still more preferably from 70 µm to 180 µm. When the thickness of the base material falls within the ranges, a semiconductor wafer is appropriately supported, and hence the occurrence of its warping and/or deflection can be prevented. When the thickness of the base material is more than 200 µm, the processability of the pressure-sensitive adhesive sheet for semiconductor processing may reduce.

The number of the base materials may be only one, or may be two or more. When the number of the base materials is two or more, the base materials may be laminated so as to be in contact with each other, or the base materials may be laminated through intermediation of any other layer. When the number of the base materials is two or more, the base materials are used so that the total thickness of all base materials in the pressure-sensitive adhesive sheet for semiconductor processing may be the above-mentioned thickness of the base material.

The base material may be formed of any appropriate resin. Specific examples of the resin for forming the base material include polyester-based resins, such as polyethylene naphthalate (PEN), polybutylene terephthalate (PBT), and polybutylene naphthalate (PBN), polyolefin-based resins, such as an ethylenevinyl acetate copolymer, an ethylene-methyl methacrylate copolymer, polyethylene, polypropylene, and an ethylenepropylene copolymer, polyvinyl alcohol, polyvinylidene chloride, polyvinyl chloride, a vinyl chloride-vinyl acetate copolymer, polyvinyl acetate, polyamide, polyimide, celluloses, a fluorine-based resin, polyether, polystyrene-based resins, such as polystyrene, polycarbonate, polyether sulfone, and polyetheretherketone. Of those, polyethylene naphthalate, polyimide, and polyetheretherketone are preferably used. When any such resin is used, even in the case where the pressure-sensitive adhesive sheet for semiconductor processing is subjected to a heating process, the sheet can appropriately support a semiconductor wafer. In addition, the shrinkage of the base material can be suppressed after the heating process, and hence a base material having a small shrinkage stress can be formed.

The base material may further include another component to the extent that the effects of the present invention are not inhibited. Examples of the other component include an antioxidant, a UV absorber, a light stabilizer, and a heat stabilizer. With regard to the kind and usage amount of the other component, the other component may be used in any appropriate amount in accordance with purposes.

### C. Pressure-sensitive Adhesive Layer

The pressure-sensitive adhesive layer is formed by using any appropriate pressure-sensitive adhesive layer-forming composition. In at least one embodiment of the present invention, the pressure-sensitive adhesive layer-forming composition (the resulting pressure-sensitive adhesive layer) contains a UV-curable pressure-sensitive adhesive. When the UV-curable pressure-sensitive adhesive is incorporated, the pressure-sensitive adhesive sheet having excellent pressure-sensitive adhesive strength to an adherend before UV irradiation and excellent peelability after UV irradiation can be provided.

### C-1. UV-curable Pressure-sensitive Adhesive

Any appropriate pressure-sensitive adhesive may be used as the UV-curable pressure-sensitive adhesive. For example, a pressure-sensitive adhesive obtained by adding a UV-curable monomer and/or oligomer to any appropriate pressure-sensitive adhesive, such as an acrylic pressure-sensitive adhesive, a rubber-based pressure-sensitive adhesive, a silicone-based pressure-sensitive adhesive, or a polyvinyl ether-based pressure-sensitive adhesive, may be adopted, or a pressure-sensitive adhesive using a polymer having a polymerizable carbon-carbon double bond in a side chain or at a terminal thereof as a base polymer may be adopted.

When the pressure-sensitive adhesive using a polymer having a polymerizable carbon-carbon double bond in a side chain or at a terminal thereof is used, a polymer having a polymerizable carbon-carbon double bond in a side chain or at a terminal thereof and having a pressure-sensitive adhesive property is used as the base polymer. Examples of such polymer include polymers each obtained by introducing a polymerizable carbon-carbon double bond into a resin, such as a (meth)acrylic resin, a vinyl alkyl ether-based resin, a silicone-based resin, a polyester-based resin, a polyamide-based resin, a urethane-based resin, or a styrene-diene block copolymer. Of those, a (meth)acrylic polymer obtained by introducing a polymerizable carbon-carbon double bond into a (meth)acrylic resin is preferably used. When the (meth)acrylic polymer is used, a pressure-sensitive adhesive sheet in which the storage modulus of elasticity and tensile modulus of elasticity of the pressure-sensitive adhesive layer are easily adjusted, and which is excellent in balance between pressure-sensitive adhesive strength and peelability can be obtained. Further, contamination of an adherend by a component derived from the pressure-sensitive adhesive can be reduced. The "(meth)acrylic" refers to acrylic and/or methacrylic.

Any appropriate (meth) acrylic resin may be used as the (meth)acrylic resin. An example of the (meth)acrylic resin is a polymer obtained by polymerizing a monomer composition containing one kind or two or more kinds of esters of acrylic acid or methacrylic acid each having a linear or branched alkyl group.

The linear or branched alkyl group is preferably an alkyl group having 30 or less carbon atoms, more preferably an alkyl group having 1 to 20 carbon atoms, still more preferably an alkyl group having 4 to 18 carbon atoms. Specific examples of the alkyl group include a methyl group, an ethyl group, a propyl group, an isopropyl group, a n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group.

The monomer composition for forming the (meth)acrylic resin may contain any appropriate other monomer. Examples of the other monomer include functional group-containing monomers including: carboxyl group-containing monomers, such as acrylic acid, methacrylic acid, carboxyethyl acrylate, carboxypentyl acrylate, itaconic acid, maleic acid, fumaric acid, and crotonic acid; acid anhydride monomers, such as maleic anhydride and itaconic anhydride; hydroxyl group-containing monomers, such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, (4-hydroxymethylcyclohexyl)-methyl acrylate, 2-hydroxyethyl vinyl ether, 4-hydroxybutyl vinyl ether, and diethylene glycol monovinyl ether; sulfonic acid group-containing monomers, such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; and phosphoric acid group-containing monomers, such as 2-hydroxyethylacryloyl phosphate. The incorporation of the functional group-containing monomer can provide a (meth)acrylic resin into which a polymerizable carbon-carbon double bond is easily introduced. The content ratio of the functional group-containing monomer is preferably from 4 parts by weight to 30 parts by weight, more preferably from 6 parts by weight to 20 parts by weight with respect to 100 parts by weight of all the monomers of the monomer composition.

As the other monomer, a polyfunctional monomer may be used. When the polyfunctional monomer is used, for example, cohesive strength, heat resistance, or an adhesive property of the pressure-sensitive adhesive can be improved. In addition, the amount of the low-molecular-weight component in the pressure-sensitive adhesive layer is reduced, and hence the pressure-sensitive adhesive sheet that hardly contaminates an adherend can be obtained. Examples of the polyfunctional monomer include hexanediol (meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylate, polyester (meth)acrylate, and urethane (meth)acrylate. The content ratio of the polyfunctional monomer is preferably from 1 part by weight to 100 parts by weight, more preferably from 5 parts by weight to 50 parts by weight with respect to 100 parts by weight of all the monomers of the monomer composition.

The (meth)acrylic resin has a weight-average molecular weight of preferably 300,000 or more, more preferably 500,000 or more, still more preferably from 800,000 to 3,000,000. When the weight-average molecular weight falls within such ranges, bleeding of the low-molecular-weight component can be prevented, and hence the pressure-sensitive adhesive sheet having a low contamination property can be obtained. The (meth)acrylic resin has a molecular weight distribution (weight-average molecular weight/number-average molecular weight) of preferably from 1 to 20, more preferably from 3 to 10. When the (meth)acrylic resin having a narrow molecular weight distribution is used, bleeding of the low-molecular-weight component can be prevented, and hence the pressure-sensitive adhesive sheet having a low contamination property can be obtained. The weight-average molecular weight and the number-average molecular weight may be determined by gel permeation chromatography measurement (solvent: tetrahydrofuran, polystyrene equivalent).

The polymer having a polymerizable carbon-carbon double bond in a side chain or at a terminal thereof may be obtained by any appropriate method. The polymer may be obtained by, for example, subjecting a resin obtained by any appropriate polymerization method and a compound having a polymerizable carbon-carbon double bond to a reaction (e.g., condensation reaction or addition reaction). Specifically, when the (meth)acrylic resin is used, the resin may be obtained by subjecting a (meth)acrylic resin (copolymer) having a structural unit derived from a monomer having any appropriate functional group to polymerization in any appropriate solvent, and then subjecting the resultant to a reaction between a functional group of the acrylic resin and the compound having a polymerizable carbon-carbon double bond that may react with the functional group. The amount of the compound having a polymerizable carbon-carbon double bond to be subjected to the reaction is preferably from 4 parts by weight to 30 parts by weight, more preferably from 4 parts by weight to 20 parts by weight with respect to 100 parts by weight of the above-mentioned resin. As the solvent, any appropriate solvent may be used. Examples thereof include various organic solvents, such as ethyl acetate, methyl ethyl ketone, and toluene.

When the resin and the compound having a polymerizable carbon-carbon double bond are subjected to a reaction with each other as described above, the resin and the compound having a polymerizable carbon-carbon double bond preferably have functional groups that can react with each other. The combination of the functional groups is, for example, a carboxyl group/an epoxy group, a carboxyl group/an aziridine group, or a hydroxyl group/an isocyanate group. Of those combinations of the functional groups, a combination of a hydroxyl group and an isocyanate group is preferred from the viewpoint of ease of reaction tracking.

Examples of the compound having a polymerizable carbon-carbon double bond include 2-isocyanatoethyl methacrylate, methacryloyl isocyanate, 2-methacryloyloxyethyl isocyanate (2-isocyanatoethyl methacrylate), and m-isopropenyl-α,α-dimethylbenzyl isocyanate.

When the pressure-sensitive adhesive obtained by adding the UV-curable monomer and/or oligomer is used, any appropriate monomer or oligomer may be used as each of the UV-curable monomer and oligomer. Examples of the UV-curable monomer include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the UV-curable oligomer include a urethane-based oligomer, a polyether-based oligomer, a polyester-based oligomer, a polycarbonate-based oligomer, and a polybutadiene-based oligomer. An oligomer having a molecular weight of from about 100 to about 30,000 is preferably used as the oligomer. The monomers and the oligomers may be used alone or in combination thereof.

The monomer and/or oligomer may be used in any appropriate amount in accordance with the kind of the pressure-sensitive adhesive to be used. The amount of the monomer and/or oligomer to be used is, for example, preferably from 5 parts by weight to 500 parts by weight, more preferably from 40 parts by weight to 150 parts by weight with respect to 100 parts by weight of the base polymer for forming the pressure-sensitive adhesive.

### C-2. Photopolymerization Initiator

Any appropriate initiator may be used as the photopolymerization initiator. Examples of the photopolymerization initiator include: acyl phosphine oxide-based photopolymerization initiators, such as ethyl 2,4,6-trimethylbenzylphenyl phosphinate and (2,4,6-trimethylbenzoyl)-phenylphosphine oxide; α-ketol-based compounds, such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether-based compounds, such as benzoin ethyl ether, benzoin isopropyl ether, and anisoin methyl ether; ketal-based compounds, such as benzyl dimethyl ketal; aromatic sulfonyl chloride-based compounds, such as 2-naphthalenesulfonyl chloride; photoactive oxime-based compounds, such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; and acyl phosphonates, and α-hydroxyacetophenones, such as 2-hydroxy-1-(4-(4-(2-hydroxy-2-methylpropionyl)benzyl)phenyl-2-methylpropane-1. Of those, acetophenone-based compounds may be preferably used. The photopolymerization initiators may be used alone or in combination thereof.

As the photopolymerization initiator, a commercially available product may also be used. Examples thereof include products available under the product names of Omnirad 127, Omnirad 369, and Omnirad 651 from IGM Resins B.V.

The photopolymerization initiator may be used in any appropriate amount. The content of the photopolymerization initiator is preferably from 0.5 part by weight to 20 parts by weight, more preferably from 0.5 part by weight to 10 parts by weight with respect to 100 parts by weight of the above-mentioned UV-curable pressure-sensitive adhesive. When the content of the photopolymerization initiator is less than 0.5 part by weight, the UV-curable pressure-sensitive adhesive may not be sufficiently cured at the time of UV irradiation. When the content of the photopolymerization initiator is more than 10 parts by weight, the storage stability of the pressure-sensitive adhesive may reduce.

### C-3. Additive

The pressure-sensitive adhesive layer-forming composition may contain any appropriate additive as required. Examples of the additive include a cross-linking agent, a catalyst (e.g., a platinum catalyst), a tackifier, a plasticizer, a pigment, a dye, a filler, an age resistor, a conductive material, a UV absorber, a light stabilizer, a peeling modifier, a softener, a surfactant, a flame retardant, and a solvent.

In at least one embodiment of the present invention, the UV-curable pressure-sensitive adhesive further contains a cross-linking agent. Examples of the cross-linking agent include an isocyanate-based cross-linking agent, an epoxy-based cross-linking agent, an aziridine-based cross-linking agent, and a chelate-based cross-linking agent. The content ratio of the cross-linking agent is preferably from 0.01 part by weight to 10 parts by weight, more preferably from 0.02 part by weight to 5 part by weight, still more preferably from 0.025 part by weight to 0.5 part by weight with respect to 100 parts by weight of the base polymer in the UV-curable pressure-sensitive adhesive. The flexibility of the pressure-sensitive adhesive layer can be controlled by the content ratio of the cross-linking agent. When the content of the cross-linking agent is less than 0.01 part by weight, the pressure-sensitive adhesive becomes sol, and hence the pressure-sensitive adhesive layer may not be formed. When the content of the cross-linking agent is more than 10 parts by weight, adhesiveness to an adherend may reduce, and the adherend may not be sufficiently protected.

In at least one embodiment of the present invention, the isocyanate-based cross-linking agent is preferably used. The isocyanate-based cross-linking agent is preferred because the cross-linking agent can react with various kinds of functional groups. A cross-linking agent having 3 or more isocyanate groups is particularly preferably used. When the isocyanate-based cross-linking agent is used as the cross-linking agent and the content ratio of the cross-linking agent falls within the above-mentioned ranges, the pressure-sensitive adhesive layer excellent in peelability even after heating and causing a remarkably reduced amount of an adhesive residue can be formed.

The thickness of the pressure-sensitive adhesive layer may be set to any appropriate value. The thickness of the pressure-sensitive adhesive layer is preferably from 10 µm to 500 µm, more preferably from 30 µm to 300 µm, still more preferably from 50 µm to 250 µm. When the thickness of the pressure-sensitive adhesive layer falls within the ranges, the layer can exhibit sufficient pressure-sensitive adhesive strength to an adherend.

The pressure-sensitive adhesive layer may be formed of one layer, or two or more layers. When the pressure-sensitive adhesive layer is formed of two or more layers, the pressure-sensitive adhesive layer only needs to include at least one pressure-sensitive adhesive layer formed by using the pressure-sensitive adhesive layer-forming composition containing the photopolymerization initiator. When the pressure-sensitive adhesive layer is formed of two or more layers, a pressure-sensitive adhesive layer formed by using the pressure-sensitive adhesive composition containing the photopolymerization initiator is preferably formed on a surface of the pressure-sensitive adhesive sheet to be brought into contact with an adherend. A pressure-sensitive adhesive layer that is not formed of the pressure-sensitive adhesive layer-forming composition may be formed of any appropriate pressure-sensitive adhesive composition. The pressure-sensitive adhesive composition may be a UV-curable pressure-sensitive adhesive or a pressure-sensitive adhesive.

### D. Relaxing Layer

In at least one embodiment of the present invention, the pressure-sensitive adhesive sheet for semiconductor wafer processing further includes the relaxing layer. When the sheet further includes the relaxing layer, even in the case where the sheet is subjected to a heating process, the sheet can be further suppressed in occurrence of warping, and hence can more satisfactorily support a semiconductor wafer. The relaxing layer may be arranged at any appropriate position. For example, the layer may be arranged between the base material and the pressure-sensitive adhesive layer. The number of the relaxing layers to be formed may be only one, or may be two or more.

The relaxing layer may be formed by using any appropriate polymer. In at least one embodiment of the present invention, the relaxing layer preferably contains a cross-linked product obtained by cross-linking a (meth)acrylic polymer. When the layer contains the cross-linked product obtained by cross-linking the (meth)acrylic polymer, both of the handleability and processability of the pressure-sensitive adhesive sheet for semiconductor processing, and the heat resistance of the pressure-sensitive adhesive sheet for semiconductor wafer processing can be achieved. The relaxing layer containing the cross-linked product obtained by cross-linking the (meth)acrylic polymer is specifically described below.

### D-1. (Meth)acrylic Polymer

Any appropriate (meth) acrylic monomer may be used as an acrylic monomer for forming the (meth)acrylic polymer. In at least one embodiment of the present invention, the (meth)acrylic polymer is free of (meth)acrylic acid as a monomer component. When the polymer is free of (meth) acrylic acid as a monomer component, the water absorption of the relaxing layer can be suppressed, and hence the heat resistance of the pressure-sensitive adhesive sheet for semiconductor processing can be improved.

An alkyl (meth)acrylate may be typically used as the acrylic monomer. Specific examples of the alkyl (meth)acrylate include (meth)acrylic monomers each having an alkyl group having 3 to 20 carbon atoms ((meth)acrylic acid C3-C20 alkyl esters), such as propyl (meth)acrylate, isopropyl (meth)acrylate, n-butyl (meth)acrylate, isobutyl (meth)acrylate, s-butyl (meth)acrylate, pentyl (meth)acrylate, isopentyl (meth)acrylate, hexyl (meth)acrylate, heptyl (meth)acrylate, 2-ethylhexyl (meth)acrylate, octyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. Of those, a (meth)acrylic monomer having an alkyl group having 4 or less carbon atoms is preferably used. The (meth)acrylic monomers may be used alone or in combination thereof.

The content ratio of the (meth)acrylic monomer having an alkyl group having 4 or less carbon atoms in the (meth)acrylic polymer is preferably from 50 mol% to 99 mol%, more preferably from 60 mol% to 95 mol%, still more preferably from 70 mol% to 90 mol%. When the content ratio of the (meth)acrylic monomer having an alkyl group having 4 or less carbon atoms falls within the ranges, both of the handleability and the processability, and the heat resistance of the pressure-sensitive adhesive sheet for semiconductor wafer processing can be achieved. When the content ratio of the (meth)acrylic monomer having an alkyl group having over 4 carbon atoms is more than 99 mol%, the ratio of an unreacted monomer component may be increased by an influence of steric hindrance. As a result, the unreacted monomer component may serve as an outgas source in the relaxing layer to reduce the heat resistance of the pressure-sensitive adhesive sheet for semiconductor processing. The content ratio of the monomer component in the (meth)acrylic polymer refers to a content ratio in a monomer composition used in the synthesis of the (meth)acrylic polymer.

In at least one embodiment of the present invention, the (meth)acrylic polymer preferably contains a hydroxy group-containing (meth)acrylic monomer. When the polymer contains the hydroxy group-containing monomer, a (meth)acrylic polymer having a hydroxy group is obtained, and the hydroxy group may serve as an introduction point for any appropriate substituent. In addition, both of the handleability and the processability, and the heat resistance of the pressure-sensitive adhesive sheet for semiconductor wafer processing can be achieved. The content ratio of the hydroxy group-containing monomer in the (meth) acrylic polymer is preferably from 0.1 mol% to 8 mol%, more preferably from 1 mol% to 7.5 mol%. When the content ratio of the hydroxy group-containing monomer is more than 8 mol%, the relaxing layer may absorb water to reduce the heat resistance of the pressure-sensitive adhesive sheet for semiconductor processing.

Any appropriate monomer may be used as the hydroxy group-containing monomer. Examples thereof include 2-hydroxymethyl acrylate, 2-hydroxyethyl acrylate, 2-hydroxypropyl acrylate, 3-hydroxypropyl acrylate, 4-hydroxybutyl acrylate, 2-hydroxymethyl methacrylate, 2-hydroxyethyl methacrylate, and N-(2-hydroxyethyl)acrylamide. Of those, 2-hydroxymethyl acrylate, 2-hydroxyethyl acrylate, 2-hydroxymethyl methacrylate, and 2-hydroxyethyl methacrylate are preferably used. Those monomers may be used alone or in combination thereof.

In addition, another monomer component copolymerizable with the alkyl (meth) acrylate may be further used as required for the purpose of modifying, for example, cohesive strength, heat resistance, or cross-linkability. Examples of such monomer component include: acid anhydride monomers, such as maleic anhydride and itaconic anhydride; hydroxyl group-containing monomers, such as hydroxyethyl (meth)acrylate and hydroxypropyl (meth)acrylate; sulfonic acid group-containing monomers, such as styrenesulfonic acid and allylsulfonic acid; (N-substituted) amide-based monomers, such as (meth)acrylamide and N,N-dimethyl (meth)acrylamide; aminoalkyl (meth)acrylate-based monomers, such as aminoethyl (meth)acrylate; alkoxyalkyl (meth)acrylate-based monomers, such as methoxyethyl (meth)acrylate; maleimide-based monomers, such as N-cyclohexyl maleimide and N-isopropyl maleimide; itaconimide-based monomers, such as N-methyl itaconimide and N-ethyl itaconimide; succinimide-based monomers; vinyl-based monomers, such as vinyl acetate, vinyl propionate, N-vinyl pyrrolidone, and methylvinyl pyrrolidone; cyano acrylate monomers, such as acrylonitrile and methacrylonitrile; epoxy group-containing acrylic monomers, such as glycidyl (meth)acrylate; glycol-based acrylic ester monomers, such as polyethylene glycol (meth)acrylate and polypropylene glycol (meth)acrylate; acrylic acid ester-based monomers each having a heterocycle, a halogen atom, or a silicon atom, such as tetrahydrofurfuryl (meth)acrylate, fluorine (meth)acrylate, and silicone (meth)acrylate; olefin-based monomers, such as isoprene, butadiene, and isobutylene; and vinyl ether-based monomers, such as vinyl ether. Those monomer components may be used alone or in combination thereof.

In at least one embodiment of the present invention, the relaxing layer is preferably free of UV curability. When the layer is free of UV curability, even in the case where the pressure-sensitive adhesive sheet for semiconductor processing is subjected to a heating process, the occurrence of its warping can be suppressed. Any appropriate method may be used as a measure to provide the relaxing layer free of UV curability. Examples thereof include the following methods: unlike the description in the section C, no carbon-carbon double bond is introduced into the (meth)acrylic polymer, no UV-curable monomer and/or oligomer is added thereto, and no photopolymerization initiator is added thereto.

The (meth)acrylic polymer may be obtained by any appropriate method. The polymer may be obtained through, for example, the polymerization of a monomer composition containing the above-mentioned monomer component by any appropriate polymerization method.

### D-2. Cross-linking Agent

Any appropriate cross-linking agent may be used as a cross-linking agent to be used for cross-linking the (meth) acrylic polymer. For example, the cross-linking agents listed in the section C may each be used. In at least one embodiment of the present invention, an isocyanate-based cross-linking agent is preferably used. The isocyanate-based cross-linking agent is preferred because the cross-linking agent can react with various kinds of functional groups. A cross-linking agent having 3 or more isocyanate groups is particularly preferably used. The cross-linking agent may be used in any appropriate amount. The content of the cross-linking agent is preferably from 0.01 part by weight to 10 parts by weight, more preferably from 0.02 part by weight to 5 parts by weight, still more preferably from 0.025 part by weight to 0.5 part by weight with respect to 100 parts by weight of the (meth)acrylic polymer. When the content of the cross-linking agent is less than 0.01 part by weight, the state of the relaxing layer may become closer to sol to reduce the processability of the pressure-sensitive adhesive sheet for semiconductor processing. Further, when the sheet is subjected to a heating process, it may become difficult to maintain the shape of the relaxing layer, thereby contaminating a heating apparatus. When the content of the cross-linking agent is more than 10 parts by weight, there is a risk in that the relaxing layer becomes closer to gel, and hence the rubber elasticity of the relaxing layer becomes higher to preclude the relaxing layer from sufficiently exhibiting its function of alleviating the shrinkage of the base material in the heating process. As a result, the suppressing effect of the layer on the occurrence of the warping of the sheet may reduce.

### D-3. Additive

The relaxing layer may contain any appropriate additive as required. Examples of the additive include a catalyst (e.g., a platinum catalyst), a tackifier, a plasticizer, a pigment, a dye, a filler, an age resistor, a conductive material, a UV absorber, a light stabilizer, a peeling modifier, a softener, a surfactant, a flame retardant, and a solvent.

The thickness of the relaxing layer may be set to any appropriate value. The thickness is, for example, from 5 µm to 600 µm, preferably from 10 µm to 550 µm, more preferably from 20 µm to 500 µm. When the thickness of the relaxing layer falls within the ranges, even in the case where a semiconductor wafer is subjected to a heating process under a state in which the pressure-sensitive adhesive sheet for semiconductor processing is bonded thereto, the occurrence of its warping can be suppressed, and hence the conveyance of the wafer with an apparatus can be efficiently performed. Accordingly, a reduction in yield can be suppressed. When the thickness of the relaxing layer is less than 5 µm, its suppressing effect on the occurrence of the warping in the heating process may reduce. When the thickness of the relaxing layer is more than 600 µm, the possibility that the processability of the pressure-sensitive adhesive sheet for semiconductor processing reduces to reduce a yield in a process in which the pressure-sensitive adhesive sheet is bonded to the semiconductor wafer, and the bonded product is cut may become higher.

### E. Method of producing Pressure-sensitive Adhesive Sheet for Semiconductor Processing

The pressure-sensitive adhesive sheet for semiconductor processing may be produced by any appropriate method. The sheet may be obtained by, for example, a method including: applying a pressure-sensitive adhesive solution (UV-curable pressure-sensitive adhesive) to the separator; drying the solution to form the pressure-sensitive adhesive layer on the separator; and then bonding the layer to the base material. In addition, the pressure-sensitive adhesive sheet for semiconductor processing may be obtained by applying the pressure-sensitive adhesive layer-forming composition onto the base material and drying the composition. Various methods, such as bar coater coating, air knife coating, gravure coating, gravure reverse coating, reverse roll coating, lip coating, die coating, dip coating, offset printing, frexographic printing, and screen printing, can each be adopted as the coating method of the pressure-sensitive adhesive layer-forming composition. Any appropriate method can be adopted as the drying method.

When the pressure-sensitive adhesive sheet for semiconductor processing further includes the relaxing layer, the relaxing layer may be formed by any appropriate method. For example, the relaxing layer may be formed by applying a material for the relaxing layer to the base material and drying the material in the same manner as in the method of forming the pressure-sensitive adhesive layer.

### F. Applications of Pressure-sensitive Adhesive Sheet for Semiconductor Processing

The pressure-sensitive adhesive sheet for semiconductor processing may be suitably used in a semiconductor production process. As described above, even when the pressure-sensitive adhesive sheet for semiconductor processing is subjected to a heating process, the sheet is suppressed in occurrence of warping, and hence can prevent a reduction in yield. Accordingly, the sheet may be suitably used in the protection of a semiconductor wafer to be subjected to the heating process.

When the diameter of an outer peripheral rib wafer is increased, the rigidity contribution ratio of its outer peripheral rib to its ground portion reduces, and hence problems such as the occurrence of deflection and of warping when the wafer is subjected to a heating process may become more remarkable. Even when the pressure-sensitive adhesive sheet for semiconductor wafer processing is applied to an outer peripheral rib wafer increased in diameter (e.g., 12 inches), the sheet suppresses the occurrence of deflection and of warping when the wafer is subjected to the heating process, and hence can prevent a reduction in yield.

### Examples

Now, the present invention is specifically described by way of Examples, but the present invention is not limited to these Examples. In addition, in Examples, "part(s)" and "%" are by weight unless otherwise stated.

### [Production Example 1]

### Preparation of Pressure-sensitive Adhesive Layer-forming Composition

167.17 Parts by weight of butyl acrylate (BA), 12.11 parts by weight of 2-hydroxyethyl acrylate (HEA), 0.54 part by weight of azobisisobutyronitrile (AIBN), and 414.98 parts by weight of ethyl acetate were mixed to prepare a composition. The resultant composition was loaded into an experimental apparatus for polymerization with a 1-liter round-bottom separable flask with a separable cover, a separating funnel, a temperature gauge, a nitrogen-introducing tube, a Liebig condenser, a vacuum seal, a stirring rod, and a stirring blade, and while the composition was stirred, the inside of the apparatus was purged with nitrogen at normal temperature for 6 hours. After that, while the composition was stirred in a stream of nitrogen, the composition was held at 65°C for 4 hours and then at 75°C for 2 hours to be polymerized. Thus, a resin solution was obtained.

The flask containing the resultant resin solution was cooled to room temperature. After that, 8.09 parts by weight of 2-isocyanatoethyl methacrylate (manufactured by Showa Denko K.K., product name: "Karenz MOI") serving as a compound having a polymerizable carbon-carbon double bond and 0.04 part by weight of dibutyltin(IV) dilaurate (manufactured by Wako Pure Chemical Industries, Ltd.) were added to the resin solution, and the mixture was stirred under an air atmosphere at 50°C for 24 hours to provide a base polymer.

0.4 Part by weight of a polyisocyanate cross-linking agent (manufactured by Nippon Polyurethane Industry Co., Ltd., product name: "CORONATE L") and 0.5 part by weight of a photopolymerization initiator (manufactured by IGM Resins B.V., product name: "Omnirad 369") were added to 100 parts by weight of the solid content of the resultant base polymer, followed by mixing. Next, ethyl acetate was used as a diluting solvent to adjust the viscosity of the mixture. Thus, a pressure-sensitive adhesive layer-forming composition was obtained.

### [Production Example 2]

### Preparation of Relaxing Layer-forming Compositions 1 to 6

Respective materials shown in Table 1 were mixed to provide compositions. Each of the resultant compositions was loaded into an experimental apparatus for polymerization, which had been obtained by mounting a 1-liter round-bottom separable flask with a separable cover, a separating funnel, a temperature gauge, a nitrogen-introducing tube, a Liebig condenser, a vacuum seal, a stirring rod, and a stirring blade, and while the composition was stirred, the inside of the apparatus was purged with nitrogen at normal temperature for 6 hours. After that, while the composition was stirred in a stream of nitrogen, the composition was held at 65°C for 4 hours, and then at 75°C for 2 hours to be polymerized. Thus, resin solutions (relaxing layer polymers 1 to 6) were obtained.

0.2 Part by weight of a polyisocyanate cross-linking agent (manufactured by Nippon Polyurethane Industry Co., Ltd., product name: "CORONATE L") was added to 100 parts by weight of the solid content of the resultant resin solution, followed by mixing. Next, ethyl acetate was used as a diluting solvent to adjust the viscosity of the mixture. Thus, relaxing layer-forming compositions 1 to 6 were obtained.

**Table 1**

| | Relaxing layer-forming composition 1 | Relaxing layer-forming composition 2 | Relaxing layer-forming composition 3 | Relaxing layer-forming composition 4 | Relaxing layer-forming composition 5 | Relaxing layer-forming composition 6 |
|---|---|---|---|---|---|---|
| EA (part (s)) | 76.28 | 78.45 | 72.69 | 75.20 | 46.58 | 71.35 |
| BA (part (s)) | 97.69 | 0.00 | 93.10 | 96.31 | 0.00 | 91.38 |
| HEA (part (s)) | 5.31 | 4.55 | 13.49 | 5.23 | 4.55 | 16.55 |
| 2EHA (part (s)) | 0.00 | 96.29 | 0.00 | 0.00 | 128.65 | 0.00 |
| AA (part (s)) | 0.00 | 0.00 | 0.00 | 2.54 | 0.00 | 0.00 |
| AIBN (part (s)) | 0.54 | 0.54 | 0.54 | 0.54 | 0.54 | 0.54 |
| Ethyl acetate (part (s)) | 417.71 | 417.11 | 417.82 | 417.74 | 416.14 | 417.86 |

| | | | | | | |
|---|---|---|---|---|---|---|
| EA: ethyl acrylate BA: butyl acrylate HEA: 2-hydroxyethyl acrylate 2EHA: 2-ethylhexyl acrylate AA: acrylic acid AIBN: azobisisobutyronitrile | | | | | | |

### [Example 1]

One surface of a polyethylene naphthalate film having a thickness of 50 µm (manufactured by Teijin Film Solutions Limited, product name: "TEONEX (trademark) FILM Q51") was subjected to corona treatment. The relaxing layer-forming composition 1 was applied to the corona-treated surface of the film, and was dried with a drying machine at 120°C for 3 minutes to form a relaxing layer having a thickness of 40 µm.

Separately, the pressure-sensitive adhesive layer-forming composition was applied to the release-treated surface side of a polyethylene terephthalate (PET) separator (manufactured by Mitsubishi Chemical Corporation, product name: "DIAFOIL MRF38"), and was dried with a drying machine at 120°C for 3 minutes to form a pressure-sensitive adhesive layer having a thickness of 10 µm.

Next, the relaxing layer and the pressure-sensitive adhesive layer were bonded to each other with a hand roller so that no air bubbles entered a gap therebetween. Next, under a light-shielded state, the bonded product was left to stand in a drying machine set to 50°C for 48 hours, and was then removed from the drying machine. Thus, a pressure-sensitive adhesive sheet was obtained.

### [Example 2]

A pressure-sensitive adhesive sheet was obtained in the same manner as in Example 1 except that the thickness of the base material was set to 100 µm.

### [Example 3]

A pressure-sensitive adhesive sheet was obtained in the same manner as in Example 1 except that the thickness of the base material was set to 188 µm.

### [Example 4]

A pressure-sensitive adhesive sheet was obtained in the same manner as in Example 2 except that the relaxing layer-forming composition 2 was used instead of the relaxing layer-forming composition 1.

### [Example 5]

A pressure-sensitive adhesive sheet was obtained in the same manner as in Example 2 except that the relaxing layer-forming composition 3 was used instead of the relaxing layer-forming composition 1.

### [Example 6]

One surface of a polyethylene naphthalate film having a thickness of 125 µm (manufactured by Teijin Film Solutions Limited, product name: "TEONEX (trademark) FILM Q51") was subjected to corona treatment. The relaxing layer-forming composition 1 was applied to the corona-treated surface of the film, and was dried with a drying machine at 120°C for 3 minutes to form a relaxing layer having a thickness of 40 µm. Next, one surface of a polyethylene naphthalate film having a thickness of 25 µm (manufactured by Teijin Film Solutions Limited, product name: "TEONEX (trademark) FILM Q51") was subjected to corona treatment, and the surface of the film that was not subjected to the corona treatment was bonded to the relaxing layer with a hand roller so that no air bubbles entered a gap therebetween.

Separately, the pressure-sensitive adhesive layer-forming composition was applied to the release-treated surface side of a polyethylene terephthalate (PET) separator (manufactured by Mitsubishi Chemical Corporation, product name: "DIAFOIL MRF38"), and was dried with a drying machine at 120°C for 3 minutes to form a pressure-sensitive adhesive layer having a thickness of 10 µm.

Next, the corona-treated surface of the polyethylene naphthalate film having a thickness of 25 µm and the pressure-sensitive adhesive layer were bonded to each other with a hand roller so that no air bubbles entered a gap therebetween. Next, under a light-shielded state, the bonded product was left to stand in a drying machine set to 50°C for 48 hours, and was then removed from the drying machine. Thus, a pressure-sensitive adhesive sheet was obtained.

### [Example 7]

A pressure-sensitive adhesive sheet was obtained in the same manner as in Example 2 except that the relaxing layer-forming composition 4 was used instead of the relaxing layer-forming composition 1.

### [Example 8]

A pressure-sensitive adhesive sheet was obtained in the same manner as in Example 2 except that the relaxing layer-forming composition 5 was used instead of the relaxing layer-forming composition 1.

### [Example 9]

A pressure-sensitive adhesive sheet was obtained in the same manner as in Example 2 except that the relaxing layer-forming composition 6 was used instead of the relaxing layer-forming composition 1.

### (Comparative Example 1)

A pressure-sensitive adhesive sheet was obtained in the same manner as in Example 1 except that the thickness of the base material was set to 25 µm.

### (Comparative Example 2)

A pressure-sensitive adhesive sheet was obtained in the same manner as in Example 1 except that the thickness of the base material was set to 250 µm.

### (Comparative Example 3)

One surface of a polyethylene naphthalate film having a thickness of 100 µm (manufactured by Teijin Film Solutions Limited, product name: "TEONEX (trademark) FILM Q51") was subjected to corona treatment. A pressure-sensitive adhesive layer-forming composition was applied to the corona-treated surface of the film, and was dried with a drying machine at 120°C for 3 minutes to form a pressure-sensitive adhesive layer having a thickness of 50 µm. Next, the release-treated surface of a polyethylene terephthalate (PET) separator (manufactured by Mitsubishi Chemical Corporation, product name: "DIAFOIL MRF38") was bonded to the pressure-sensitive adhesive layer with a hand roller so that no air bubbles entered a gap therebetween. Next, under a light-shielded state, the bonded product was left to stand in a drying machine set to 50°C for 48 hours, and was then removed from the drying machine. Thus, a pressure-sensitive adhesive sheet was obtained.

### (Comparative Example 4)

A pressure-sensitive adhesive sheet was obtained in the same manner as in Example 1 except that a PET film having a thickness of 100 µm (manufactured by Toray Industries, Inc., product name: "LUMIRROR #100ES10") was used as a base material.

### <Evaluation>

The following evaluations were performed by using the pressure-sensitive adhesive sheets obtained in Examples and Comparative Examples, the base material-forming materials, the relaxing layer-forming compositions 1 to 6, and the pressure-sensitive adhesive layer-forming composition. The results are shown in Table 2.

### 1. Storage Modulus of Elasticity E' of Base Material

A base material-forming material was cut out into a strip shape having a film thickness of 100 µm, a length of 25 mm (measured length), and a width of 10 mm with a box cutter to provide an evaluation sample. The storage moduli of elasticity E' of the evaluation sample at from 0°C to 250°C were measured with a solid viscoelasticity-measuring apparatus (manufactured by Rheometric Scientific, product name: "RSA III"). The measurement was performed under the conditions of a frequency of 1 Hz and a rate of temperature increase of 10°C/min, and the storage modulus of elasticity E' at 22°C was adopted as the storage modulus of elasticity E' of each sample.

### 2. Evaluation of Cutting Property after Bonding

A cutting test was performed by bonding each of the resultant pressure-sensitive adhesive sheets under the following conditions. A cutter blade was exchanged with a new blade every time a tape or wafer to which the sheet was bonded was exchanged.

Bonding apparatus: DR-3000III (manufactured by Nitto Seiki Co., Ltd.)
Bonding setting: 12 inch
Bonding wafer: 12-inch Si wafer (unground)
Bonding table: 23°C
Bonding pressure: 0.4 MPa
Bonding rate: 3 mm/sec
Cutter temperature: 180°C
Cutting rate: 200 mm/sec
Cutter blade: Art Knife Replacement Blade XB10 (manufactured by Olfa Corporation)

### 3. Outer Peripheral Rib Wafer Evaluation

### (1) Production of Sample

A 12-inch Si mirror was prepared, and a pressure-sensitive adhesive tape for processing (manufactured by Nitto Denko Corporation, product name: UB-3083D) was bonded thereto with a bonding apparatus (manufactured by Nitto Seiki Co., Ltd., product name: DR-3000III), followed by cutting. Next, the width of the outer peripheral rib of the resultant Si wafer was set to 2 mm (unground, no slope processing), and the portion thereof except the rib was subjected to thinning processing to a thickness of 75 µm. Next, UV light was applied from the base material side of the pressure-sensitive adhesive tape for processing with a high-pressure mercury lamp in a light quantity of 500 mJ/cm² or more to cure the pressure-sensitive adhesive layer of the tape, followed by the peeling of the pressure-sensitive adhesive tape for processing. Thus, an outer peripheral rib wafer was obtained.

The pressure-sensitive adhesive sheet obtained in Examples or Comparative Examples was cut into a size measuring 400 mm by 400 mm. The base material surface of each pressure-sensitive adhesive sheet was placed on a floor, and its separator was peeled. Next, a dicing ring for 12 inches was bonded to the pressure-sensitive adhesive layer of the pressure-sensitive adhesive sheet under a state in which no tension was applied to the pressure-sensitive adhesive sheet. Next, the outer peripheral rib wafer and the pressure-sensitive adhesive sheet were bonded to each other with a bonding apparatus (manufactured by Nitto Seiki Co., Ltd., product name: MV 3000) (table: table out of contact with the rear surface of the wafer, bonding temperature: 23°C, degree of vacuum at the time of the bonding: 50 Pa). The flat surface of the outer peripheral rib wafer and the pressure-sensitive adhesive layer were bonded to each other. After that, the blade of a box cutter was inserted from the rib surface of the wafer to cut the pressure-sensitive adhesive sheet along the outer periphery of the wafer. Thus, an evaluation sample was produced. A deflection evaluation and a heat warping evaluation were performed by using the resultant sample.

### (2) Outer Peripheral Rib Wafer Deflection Evaluation

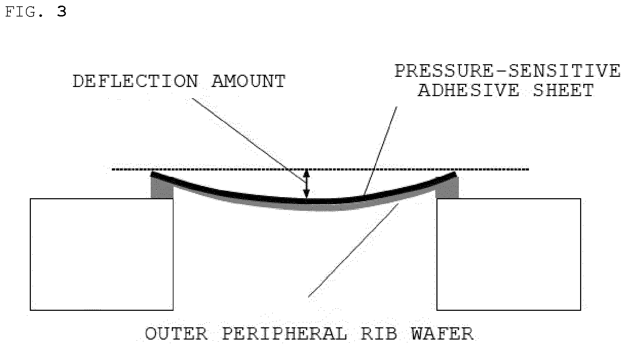

Only the outer peripheral rib of the outer peripheral rib wafer evaluation sample was placed on a support so that its recessed portion was directed downward as illustrated in FIG. **3****,** followed by the measurement of the deflection amount (mm) of the sample. The evaluation was performed under a state in which the support was arranged so as to be horizontal, and the deflection amount in the portion where the deflection amount became maximum was adopted as the deflection amount of the pressure-sensitive adhesive sheet for semiconductor processing.

### (3) Outer Peripheral Rib Wafer Heat Warping Evaluation

The outer peripheral rib wafer evaluation sample was loaded into an explosion-proof drying machine (manufactured by Espec Corp., product name: SPH-201), and was subjected to heating treatment at 180°C for 1 hour. Next, the Si surface of the evaluation sample was placed on a floor, and the warping amount (mm) of the sample (distance from the surface of the floor to an end portion of the outer peripheral rib wafer of the sample) was measured with a ruler. In addition, the presence or absence of air bubbles in the relaxing layer of the sample, and the presence or absence of the melting of the base material thereof, after the heating were visually observed.

### 4. Peel Strength

### (1) Peel Strength before Heating

The pressure-sensitive adhesive sheet obtained in Examples or Comparative Examples was cut into a strip shape measuring 150 mm long by 20 mm wide. Under 23°C, a 2-kilogram roller was reciprocated once to bond the pressure-sensitive adhesive sheet from which its separator had been peeled to a mirror-finished silicon wafer (manufactured by Shin-Etsu Semiconductor Co., Ltd., product name: "CZN<100>2.5-3.5", diameter: 4 inches). The bonding portion between the sheet and the wafer was formed so as to measure 80 mm long by 20 mm wide. The bonded product was left at rest at no load under an atmosphere at 23°C for 30 minutes. Next, the pressure-sensitive adhesive strength of the pressure-sensitive adhesive sheet was measured by performing a 90° peel test in conformity with JIS Z 0237 under the following conditions.

### <90° Peel Test>

Number of repetitions of test: 3 times
Temperature: 23°C
Peel angle: 90°
Peel rate: 300 mm/min
Initial length (chuck interval): 150 mm

### (2) Peel Strength before Heating and after UV Irradiation

The pressure-sensitive adhesive sheet obtained in Examples or Comparative Examples was cut into a strip shape measuring 150 mm long by 20 mm wide. Under 23°C, a 2-kilogram roller was reciprocated once to bond the pressure-sensitive adhesive sheet from which its separator had been peeled to a mirror-finished silicon wafer (manufactured by Shin-Etsu Semiconductor Co., Ltd., product name: "CZN<100>2.5-3.5", diameter: 4 inches). The bonding portion between the sheet and the wafer was formed so as to measure 80 mm long by 20 mm wide. The bonded product was left at rest at no load under an atmosphere at 23°C for 30 minutes. After having been left at rest for 30 minutes, the bonded product was irradiated with UV light from the back surface side of the base material of the sheet under the following UV irradiation conditions. After that, the bonded product was left at rest for 30 minutes, and a 90° peel test was performed in conformity with JIS Z 0237 in the same manner as in the evaluation of a peel strength before heating.

### <UV Irradiation Conditions>

UV irradiation apparatus: manufactured by Nitto Seiki Co., Ltd., product name: UM810
Light source: high-pressure mercury lamp
Irradiation intensity: 50 mW/cm² (measuring apparatus: manufactured by Ushio Inc. "UV Intensity Meter UT-101")
Irradiation time: 30 sec
Integrated light quantity: 1,500 mJ/cm²

### (3) Peel Strength after Heating and after UV Irradiation

The pressure-sensitive adhesive sheet obtained in Examples or Comparative Examples was cut into a strip shape measuring 150 mm long by 20 mm wide. Under 23°C, a 2-kilogram roller was reciprocated once to bond the pressure-sensitive adhesive sheet from which its separator had been peeled to a mirror-finished silicon wafer (manufactured by Shin-Etsu Semiconductor Co., Ltd., product name: "CZN<100>2.5-3.5", diameter: 4 inches). The bonding portion between the sheet and the wafer was formed so as to measure 80 mm long by 20 mm wide. The bonded product was left at rest at no load under an atmosphere at 23°C for 30 minutes. Next, the bonded product was warmed in a drying machine set to 180°C for 1 hour. After the warming, under a light-shielded state, the bonded product was left to stand in an environment at 23°C and 50%RH for 3 hours. Next, the bonded product was irradiated with UV light from the back surface side of the base material of the sheet under the following UV irradiation conditions. After that, the bonded product was left at rest for 30 minutes, and a 90° peel test was performed in conformity with JIS Z 0237 in the same manner as in the evaluation of a peel strength before heating.

### <UV Irradiation Conditions>

UV irradiation apparatus: manufactured by Nitto Seiki Co., Ltd., product name: UM810
Light source: high-pressure mercury lamp
Irradiation intensity: 50 mW/cm² (measuring apparatus: manufactured by Ushio Inc. "UV Intensity Meter UT-101")
Irradiation time: 30 sec
Integrated light quantity: 1,500 mJ/cm²

### 5. Relaxing Layer Evaluation

### (1) Production of Sample

Each of the relaxing layer-forming compositions 1 to 6 was applied to the release-treated surface of a PET separator (manufactured by Mitsubishi Chemical Corporation, product name: "DIAFOIL MRA38"), and was dried on the PET separator with a drying machine at 120°C for 3 minutes to provide a relaxing layer having a thickness of 50 µm. The release-treated surface side of another PET separator (manufactured by Mitsubishi Chemical Corporation, product name: "DIAFOIL MRF38") was bonded to the surface of the relaxing layer out of contact with the PET separator so that no air bubbles were included therebetween. The bonded product was left to stand in a drying machine set to 50°C for 48 hours to provide an evaluation sample.

### (2) Karl Fischer Water Content

The evaluation sample was cut out into two pieces each having a size measuring 1 cm by 5 cm (total area: 10 cm²). The separators on both surfaces of each piece were peeled and transferred onto aluminum foil, and the resultant sample was weighed. The sample after the weighing was loaded into a heating vaporizer (manufactured by Mitsubishi Chemical Analytech Co., Ltd., product name: MODEL VA-200), and a gas produced at 150°C was introduced into the titration cell of a coulometric titration-type water content-measuring apparatus (manufactured by Mitsubishi Chemical Analytech Co., Ltd., product name: MODEL CA-200), followed by the measurement of its water content (µg/g) .

### (3) Karl Fischer Water Content after Water Absorption

The evaluation sample was loaded into a thermo-hygrostat at 60°C and 95%RH for 72 hours. Next, the evaluation sample was cut out into two pieces each having a size measuring 1 cm by 5 cm (total area: 10 cm²). The separators on both surfaces of each piece were peeled and transferred onto aluminum foil, and the resultant sample was weighed. The sample after the weighing was loaded into a heating vaporizer (manufactured by Mitsubishi Chemical Analytech Co., Ltd., product name: MODEL VA-200), and a gas produced at 150°C was introduced into the titration cell of a coulometric titration-type water content-measuring apparatus (manufactured by Mitsubishi Chemical Analytech Co., Ltd., product name: MODEL CA-200), followed by the measurement of its water content (µg/g). It took 1 hour from the removal of the sample from the thermo-hygrostat to load the sample into the heating vaporizer to start the measurement.

### (4) Outgas Measurement

A piece measuring 1 cm by 5 cm (5 cm²) was cut out of the evaluation sample, and its separators were peeled, followed by the weighing of the resultant sample. Next, the sample was loaded into a vial bottle, and the bottle was tightly stoppered. After that, the vial bottle containing the sample was heated with a head space sampler (HSS, manufactured by Shimadzu Corporation, product name: HS-20), and 1 mL of a gas in a heated state was injected into a gas chromatograph (GC, manufactured by Shimadzu Corporation, product name: QP2010 Ultra) and subjected to measurement. The analysis was performed under the following conditions, and a total outgas amount (µg/g) was determined.

### <HSS>

Oven temperature: 200°C
Heating time: 15 min
Sample loop temperature: 240°C
Transfer line temperature: 250°C
Pressurization time: 0.50 min
Loop filling time: 0.50 min
Loop equilibrium time: 0.10 min
Injection time: 0.50 min

### <GC>

Column: DB-17 (0.250 mmΦ×30 m, df=0.5 µm)
Column temperature: 40°C (3 min)→10°C/min→280°C (13 min)
Column pressure: 49.7 kPa (40°C)
Carrier gas: He (1.0 mL/min, 40°C, fixed linear velocity mode) linear velocity: 36.1 cm/s
Injection port temperature: 250°C
Injection method: split (20:1)
Detector: FID
Detector temperature: 250°C

**Table 2**

| | | Example 1 | Example 2 | Example 3 | Example 4 | Example 5 | Example 6 | Example 7 | Example 8 | Example 9 | Comparative Example 1 | Comparative Example 2 | Comparative Example 3 | Comparative Example 4 |
|---|---|---|---|---|---|---|---|---|---|---|---|---|---|---|
| Relaxing layer composition | EA (mol%) | 48.54 | 48.54 | 48.54 | 58.25 | 46.30 | 48.54 | 47.17 | 38.83 | 45.45 | 48.54 | 48.54 | - | 48.54 |
| | BA (mol%) | 48.54 | 48.54 | 48.54 | 0.00 | 46.30 | 48.54 | 47.17 | 0.00 | 45.45 | 48.54 | 48.54 | - | 48.54 |
| | HEA (mol%) | 2.91 | 2.91 | 2.91 | 2.91 | 7.41 | 2.91 | 2.83 | 2.91 | 9.09 | 2.91 | 2.91 | - | 2.91 |
| | 2EHA (mol%) | 0.00 | 0.00 | 0.00 | 38.83 | 0.00 | 0.00 | 0.00 | 58.25 | 0.00 | 0.00 | 0.00 | - | 0.00 |
| | AA (mol%) | 0.00 | 0.00 | 0.00 | 0.00 | 0.00 | 0.00 | 2.83 | 0.00 | 0.00 | 0.00 | 0.00 | - | 0.00 |
| | Total (mol%) | 100.00 | 100.00 | 100.00 | 100.00 | 100.00 | 100.00 | 100.00 | 100.00 | 100.00 | 100.00 | 100.00 | - | 100.00 |
| Relaxing layer | Karl Fischer water content (µg/g) | 1,600 | 1,600 | 1,600 | 1,500 | 1,700 | 1,600 | 3,200 | 1,400 | 2,100 | 1,600 | 1,600 | - | 1,600 |
| | Karl Fischer water content after moisture absorption (µg/g) | 1,700 | 1,700 | 1,700 | 1,600 | 2,800 | 1,700 | 5,100 | 1,500 | 3,200 | 1,700 | 1,700 | - | 1,700 |
| | GC outgas amount (µg/g) | 470 | 470 | 470 | 760 | 460 | 470 | 570 | 2,200 | 450 | 470 | 470 | - | 470 |
| | Alkyl monomer having 4 or less carbon atoms (mol%) | 97.09 | 97.09 | 97.09 | 58.25 | 92.59 | 97.09 | 94.34 | 38.83 | 90.91 | 97.09 | 97.09 | - | 97.09 |
| | Presence or absence of AA | Absent | Absent | Absent | Absent | Absent | Absent | Present | Absent | Absent | Absent | Absent | Absent | Absent |
| | Presence or absence of relaxing layer | Present | Present | Present | Present | Present | Present | Present | Present | Present | Present | Present | Absent | Present |
| | Kind | Relaxing layer 1 | Relaxing layer 1 | Relaxing layer 1 | Relaxing layer 2 | Relaxing layer 3 | Relaxing layer 1 | Relaxing layer 4 | Relaxing layer 5 | Relaxing layer 6 | Relaxing layer 1 | Relaxing layer 1 | - | Relaxing layer 1 |
| Base material | Thickness (µm) | 50 | 100 | 188 | 100 | 100 | 125/25 | 100 | 100 | 100 | 25 | 250 | 100 | 100 |
| | Storage modulus of elasticity at 23°C (Pa) | 2.8×10^9 | | | | | | | | | | | | 1.3×10^9 |
| | Storage modulus of elasticity at 180°C (Pa) | 2.3×10^8 | | | | | | | | | | | | 1.1×10^9 |
| | Peel strength before heating (N/20 mm) | 5.7 | 7.4 | 9.8 | 7.5 | 7.7 | 8.0 | 7. 6 | 7.5 | 7.4 | 5.5 | 13.4 | 7.2 | 7.5 |
| | Peel strength before heating and after UV irradiation (N/20 mm) | 0.1 | 0.3 | 0.4 | 0.3 | 0.3 | 0.4 | 0.6 | 0.3 | 0.3 | 0.1 | 0.8 | 0.2 | 0.3 |
| | Peel strength after heating and after UV irradiation (N/20 mm) | 0.5 | 0.8 | 0. 9 | 0.8 | 0.8 | 0. 9 | 1.2 | 0.8 | 0.8 | 0.4 | 1.5 | 0.8 | Unmeasurable |
| | Cutting property after bonding of tape | ○ | ○ | ○ | ○ | ○ | ○ | ○ | ○ | ○ | ○ | × Experime nt ended without cutting of tape | ○ | ○ |
| | Wafer deflection amount after bonding of outer peripheral rib wafer (mm) | 4 | 2.8 | 1.0 | 2.5 | 2.8 | 2.0 | 2.8 | 2.8 | 2.8 | 6.0 | - | 2.8 | 3.0 |
| Pressure-sensitive adhesive sheet | Air bubbles from relaxing layer after bonding of outer peripheral rib wafer and after heating at 180°C for 1 h | Absent | Absent | Absent | Absent | Absent | Absent | Absent | Presen t | Presen t | Absent | - | Absent | Absent |
| | Melting of base material after bonding of outer peripheral rib wafer and after heating at 180°C for 1 h | Absent | Absent | Absent | Absent | Absent | Absent | Absent | Absent | Absent | Absent | - | Absent | Present |
| | Wafer warping amount after bonding of outer peripheral rib wafer and after heating at 180°C for 1 h (mm) | 0.2 | 1.0 | 4.0 | 0.5 | 1.2 | 1.1 | 1.0 | 1.0 | 1.0 | 0 | - | 10.0 | Evaluation could not be performed because base material melted |

The pressure-sensitive adhesive sheet for semiconductor processing according to at least one embodiment of the present invention may be suitably used in a semiconductor processing process. The pressure-sensitive adhesive sheet for semiconductor processing according to at least one embodiment of the present invention may also be suitably used in the processing of a large-diameter outer peripheral rib wafer.

According to at least one embodiment of the present invention, there can be provided the pressure-sensitive adhesive sheet for semiconductor processing that appropriately protects a semiconductor wafer without reducing a yield. At the time of an increase in diameter of an outer peripheral rib wafer, problems such as deflection and warping at the time of its heat processing may become more remarkable. The pressure-sensitive adhesive sheet for semiconductor processing according to at least one embodiment of the present invention can appropriately protect even a semiconductor wafer increased in diameter, such as an outer peripheral rib wafer, without reducing a yield.

## Claims

1. A pressure-sensitive adhesive sheet for semiconductor processing, comprising:
a pressure-sensitive adhesive layer; and
a base material,
the pressure-sensitive adhesive sheet for semiconductor processing showing a warping amount of from 0 mm to 5 mm in an outer peripheral rib wafer heat warping evaluation, and showing a deflection amount of from 0 mm to 5 mm in an outer peripheral rib wafer deflection evaluation.

2. The pressure-sensitive adhesive sheet for semiconductor processing according to claim 1, wherein the base material has a storage modulus of elasticity of 2×10⁹ Pa or more at 23°C, and has a storage modulus of elasticity of 2×10⁸ Pa or more at 180°C.

3. The pressure-sensitive adhesive sheet for semiconductor processing according to claim 1 or 2, wherein the base material has a thickness of from 50 µm to 200 µm.

4. The pressure-sensitive adhesive sheet for semiconductor processing according to any one of claims 1 to 3, further comprising a relaxing layer.

5. The pressure-sensitive adhesive sheet for semiconductor processing according to claim 4, wherein the relaxing layer contains a cross-linked product obtained by cross-linking a (meth)acrylic polymer.

6. The pressure-sensitive adhesive sheet for semiconductor processing according to claim 5, wherein the (meth)acrylic polymer is free of (meth)acrylic acid as a monomer component.

7. The pressure-sensitive adhesive sheet for semiconductor processing according to claim 5 or 6, wherein the (meth)acrylic polymer contains 0.1 mol% to 8 mol% of a hydroxy group-containing (meth)acrylic monomer.

8. The pressure-sensitive adhesive sheet for semiconductor processing according to any one of claims 5 to 7, wherein the (meth)acrylic polymer contains 50 mol% to 99 mol% of a (meth)acrylic monomer having an alkyl group having 4 or less carbon atoms.

9. The pressure-sensitive adhesive sheet for semiconductor processing according to any one of claims 1 to 8, wherein the pressure-sensitive adhesive layer contains a UV-curable pressure-sensitive adhesive.

10. The pressure-sensitive adhesive sheet for semiconductor processing according to any one of claims 4 to 9, wherein the relaxing layer is free of UV curability.
